# EUROPEAN PATENT APPLICATION

(11) **EP 4 704 511 A1**
(43) Date of publication of application: **04.03.2026**
(21) Application number: 24768883.1
(22) Date of filing: 09.07.2024
(51) Int. Cl.: H10B 12/00

(54) **MEMORY AND ELECTRONIC DEVICE**

(71) Applicant: CXMT Corporation, Hefei, Anhui 230601 (CN)
(72) Inventor: LIN, Chao, Hefei, Anhui 230601 (CN)
(74) Representative: Gulde & Partner
(86) International application number: PCT/CN2024/104531
(87) International publication number: WO 2026/011311

(57) **Abstract**

A memory and an electronic device are provided. The memory includes a plurality of bit line functional groups, a plurality of memory cells, a first staircase structure, and a second staircase structure located on a base substrate; the plurality of bit line function groups are spaced apart along a first direction perpendicular to the base substrate, each bit line function group includes a first bit line, a second bit line coupled to the first bit line, and a third bit line coupled to the first bit line, the first bit line extending along a second direction parallel to the base substrate, the second bit line and the third bit line extending along a third direction parallel to the base substrate, and the second direction intersecting with the third direction; the second bit line and the plurality of memory cells are located on one side of the first bit line in the third direction, the third bit line, the first staircase structure, and the second staircase structure are located on the other side of the first bit line in the third direction, and the first staircase structure and the second staircase structure are located on opposite sides of the third bit line in the second direction. The stack structure in the memory is compact, which is beneficial to increasing the number of dies that can be cut out from each wafer.

## Description

### TECHNICAL FIELD

Embodiments of the present disclosure relate to the technical field of semiconductors, in particular to a memory and an electronic device.

### BACKGROUND

With the development of semiconductor technology, to further miniaturize the device structure in memories, the process has shifted from two-dimensional to three-dimensional, that is, arranging various memory cells and related signal lines within a memory in three-dimensional space has become the main development direction of current memory structure research.

For example, in some three-dimensional memories, the stack structure includes vertically stacked memory cells, vertically extending word lines, and horizontally extending and vertically stacked bit lines; the bit lines are connected to the external through a staircase structure disposed at the edge of the stack structure. For example, conductive steps (stairs) are layered in a staircase structure so that the bit lines can be electrically connected to circuit structures (e.g., sense amplifiers) disposed outside the stack structure through the corresponding conductive steps and contact plugs located thereon.

However, as the storage density continues to increase, the tiers of the stack structure need to be continuously increased, which poses challenges to the arrangement of the staircase structure.

### SUMMARY

According to a first aspect of the embodiments of the present disclosure, provided is a memory, which includes a plurality of bit line functional groups, a plurality of memory cells, a first staircase structure, and a second staircase structure located on a base substrate. The plurality of bit line functional groups are spaced apart along a first direction perpendicular to the base substrate, and each bit line functional group of the plurality of bit line functional groups includes a first bit line, a second bit line coupled to the first bit line, and a third bit line coupled to the first bit line, the first bit line extending along a second direction parallel to the base substrate, the second bit line and the third bit line extending along a third direction parallel to the base substrate, and the second direction intersecting with the third direction; the second bit line and the plurality of memory cells are located on one side of the first bit line in the third direction, the third bit line, the first staircase structure, and the second staircase structure are located on the other side of the first bit line in the third direction, and the first staircase structure and the second staircase structure are located on opposite sides of the third bit line in the second direction; the plurality of memory cells are each coupled to a corresponding second bit line, each staircase structure of the first staircase structure and the second staircase structure includes a plurality of conductive steps extending along the second direction, and each conductive step is coupled to a corresponding third bit line.

In some embodiments, each of the first bit line, the second bit line, and the third bit line is ring-shaped.

In some embodiments, the first bit line, the second bit line, and the third bit line have the same material composition.

In some embodiments, the memory further includes a first isolation column, a second isolation column, and a third isolation column located on the base substrate, where the first bit line circumferentially surrounds the first isolation column, the second bit line circumferentially surrounds the second isolation column, and the third bit line circumferentially surrounds the third isolation column.

In some embodiments, the first isolation column, the second isolation column, and the third isolation column have the same material composition.

In some embodiments, each staircase structure of the first staircase structure and the second staircase structure includes a plurality of conductive step groups, and each conductive step group includes at least two conductive steps spaced apart along the first direction perpendicular to the base substrate and having different extension lengths; in each conductive step group, a conductive step with a smaller extension length is farther away from the base substrate than a conductive step with a larger extension length.

In some embodiments, each staircase structure of the first staircase structure and the second staircase structure includes a first conductive step and a second conductive step, the first conductive step and the second conductive step have substantially the same extension length, the first conductive step is closer to a middle of the third bit line than the second conductive step, and the first conductive step is closer to the base substrate than the second conductive step.

In some embodiments, the first staircase structure includes a third conductive step, and the second staircase structure includes a fourth conductive step; orthographic projections of the third conductive step and the fourth conductive step on the base substrate are arranged along the second direction, the third conductive step and the fourth conductive step have substantially the same extension length, and the third conductive step is farther away from the base substrate than the fourth conductive step.

In some embodiments, each conductive step in the first staircase structure is farther away from the base substrate than any one conductive step in the second staircase structure.

In some embodiments, the memory further includes a plurality of contact plugs located on the conductive steps in a one-to-one correspondence, where each contact plug is integrally formed with a corresponding conductive step.

In some embodiments, memory cells coupled to each second bit line are disposed on opposite sides of the each second bit line in the second direction.

In some embodiments, each memory cell includes an access transistor coupled to a corresponding second bit line and a capacitor coupled to the access transistor.

In some embodiments, the access transistor includes a first gate, a first active layer surrounding the first gate, and a first gate dielectric layer between the first gate and the first active layer; the first gates oppositely arranged along the first direction are connected to form a word line, the first gate dielectric layers oppositely arranged along the first direction are connected to form an integrated structure, and the first active layers oppositely arranged along the first direction are spaced apart and are each coupled to a corresponding second bit line.

In some embodiments, the capacitor includes a first electrode, a second electrode surrounding the first electrode, and a capacitor dielectric layer between the first electrode and the second electrode; the first electrodes oppositely arranged along the first direction are connected to form an integrated structure, the capacitor dielectric layers oppositely arranged along the first direction are connected to form an integrated structure, and the second electrodes oppositely arranged along the first direction are spaced apart and are each coupled to a corresponding access transistor.

In some embodiments, the number of the second bit lines is set to be plural.

In some embodiments, the memory further includes a plurality of select transistors, where in each bit line functional group, each second bit line is coupled to the first bit line through one corresponding select transistor.

In some embodiments, the select transistor includes a second gate, a second active layer surrounding the second gate, and a second gate dielectric layer between the second gate and the second active layer; the second gates oppositely arranged along the first direction are connected to form a select control line, the second gate dielectric layers oppositely arranged along the first direction are connected to form an integrated structure, and the second active layers oppositely arranged along the first direction are spaced apart and are respectively coupled to a corresponding first bit line and a corresponding second bit line.

According to a second aspect of the embodiments of the present disclosure, provided is an electronic device, which includes a processor and the memory provided according to any one embodiment of the present disclosure. The memory is coupled to the processor.

In the memory provided in the embodiments of the present disclosure, the extension length of the second bit line can be set according to the number of the memory cells coupled thereto, the extension length of the first bit line can be set according to the number of the second bit lines coupled thereto, and the extension length of the third bit line can be set according to the arrangement of the staircase structures coupled thereto, so that the stack structure in the memory can be more compact (i.e., the planar shape thereof has a circumscribed rectangle with a small area), thereby helping to increase the yield of memory chips on each wafer (i.e., the number of dies that can be cut out from each wafer, Die Per Wafer (DPW)).

### BRIEF DESCRIPTION OF DRAWINGS

FIG. 1A is a schematic diagram of a partial planar structure of a three-dimensional memory;
FIG. 1B is a schematic diagram of a section taken along line K1-K2 in FIG. 1A;
FIG. 2A is a schematic diagram of a partial planar structure of a memory provided according to some embodiments of the present disclosure;
FIG. 2B is a schematic diagram of a section taken along line A1-A2 in FIG. 2A;
FIG. 2C is a schematic diagram of a section taken along line B1-B2 in FIG. 2A;
FIG. 2D is a schematic diagram of a section taken along line C1-C2 in FIG. 2A;
FIG. 3 is a schematic structural diagram of a memory cell provided according to some embodiments of the present disclosure;
FIG. 4 is a schematic diagram of a partial planar structure of another memory provided according to some embodiments of the present disclosure;
FIGS. 5A-5C are schematic diagrams of partial sectional structures of some stages in a manufacturing process of a memory provided according to some embodiments of the present disclosure;
FIGS. 6A-6F are schematic diagrams of partial sectional structures of other stages in a manufacturing process of a memory provided according to other embodiments of the present disclosure; and
FIG. 7 is a block diagram illustrating a structure of an electronic device provided according to some embodiments of the present disclosure.

### DESCRIPTION OF EMBODIMENTS

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. Advantages and features of the present disclosure will become apparent from the following description and claims. It should be noted that the drawings are all in a very simplified form and not to precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between a top surface and a bottom surface of a continuous structure, or a layer may be located between any pair of horizontal planes at the top surface and the bottom surface of the continuous structure. A layer may extend horizontally, vertically, and/or along inclined surfaces. A layer may include a plurality of sub-layers.

In the embodiments of the present disclosure, the term "couple" means that two (or more) conductive structures are operatively connected to each other, and may include, but are not limited to, the following cases according to actual needs: 1) the two conductive structures are directly electrically connected; 2) the two conductive structures are indirectly electrically connected (through other conductive structures); 3) one of the two conductive structures may control an electrical property of the other of the two conductive structures in response to an electrical signal although no electrical connection is made between the two conductive structures (e.g., an insulating layer is provided therebetween), e.g., a gate (or word line) is coupled to an active region (or channel region).

It should be noted that unless conflicting, the technical solutions and the technical features described in the embodiments of the present disclosure may be arbitrarily combined.

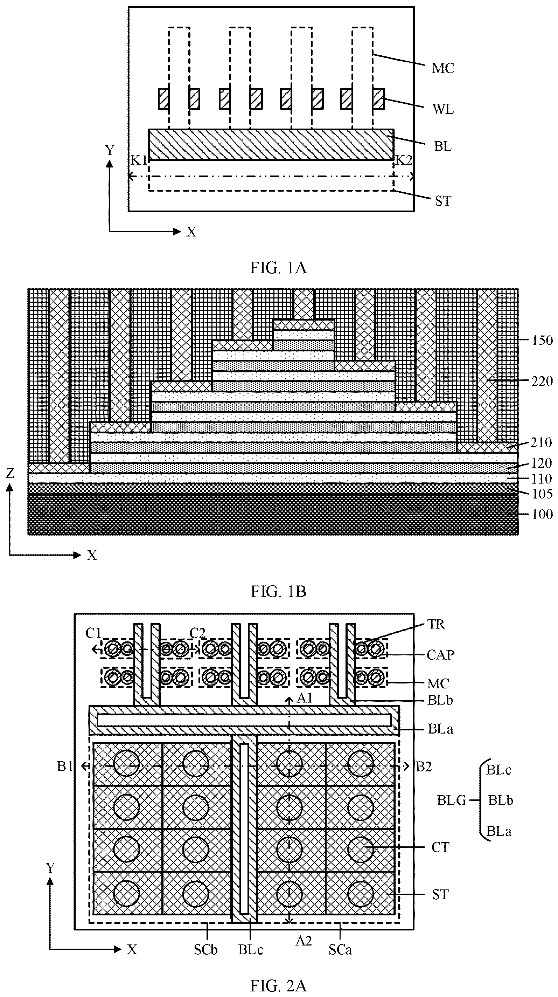

FIG. 1A is a schematic diagram of a planar structure of a three-dimensional memory, and FIG. 1B is a schematic diagram of a section taken along line K1-K2 in FIG. 1A. As shown in FIGS. 1A and 1B, the three-dimensional memory includes a plurality of tiers sequentially stacked along a vertical direction Z, and each tier includes a bit line BL extending in a horizontal direction X and a plurality of memory cells MC coupled to the bit line BL. For example, each memory cell may include a transistor coupled to the bit line BL and a capacitor coupled to the transistor.

As shown in FIGS. 1A and 1B, the three-dimensional memory further includes a plurality of word lines WL extending along the vertical direction Z, and each word line WL is coupled to the plurality of memory cells MC vertically stacked. Specifically, each word line WL is coupled to transistors in the plurality of memory cells MC vertically stacked. As shown in FIGS. 1A and 1B, the word lines WL and the memory cells MC are located on one side (the same side) of the bit line BL in the horizontal direction Y.

As shown in FIGS. 1A and 1B, the three-dimensional memory further includes a staircase structure on the other side of the bit line BL in the horizontal direction Y, and the staircase structure includes a plurality of conductive steps 210 coupled to the plurality of bit lines WL in different tiers in a one-to-one correspondence. For example, as shown in FIGS. 1A and 1B, the plurality of conductive steps 210 constitute two ascending steps (the distance from the conductive step 210 to a base substrate 100 gradually increases as viewed from the edge toward the center of the staircase structure). As shown in FIGS. 1A and 1B, the three-dimensional memory further includes a contact plug 220 on each conductive step 210, so that the bit line BL can be electrically connected to a circuit structure (e.g., a sense amplifier) provided outside the stack structure through the conductive steps 210 and the contact plugs 220.

Also schematically illustrated in FIG. 1B are a base substrate 100, an etching stop layer 105, a first dielectric layer 110, a second dielectric layer 120, and a planarization layer 150, and reference may be made to the description of the embodiments below for these structures/layers.

In the three-dimensional memory shown in FIGS. 1A and 1B, the extension length of the bit line BL is generally set according to the number of memory cells MC coupled thereto, in consideration of the limited driving capability of the circuit structure; in another aspect, since the contact plug 220 is disposed on the conductive step 210, the area of the conductive step 210 cannot be decreased infinitely, that is, the number of conductive steps 210 in the staircase structure described above is limited in the case where the extension length of the bit line BL is determined, and thus the increase of the tiers of the stack structure will also be limited.

In at least some embodiments of the present disclosure, provided is a memory. The memory includes a plurality of bit line functional groups, a plurality of memory cells, a first staircase structure, and a second staircase structure located on a base substrate. The plurality of bit line functional groups are spaced apart along a first direction perpendicular to the base substrate, and each bit line functional group of the plurality of bit line functional groups includes a first bit line, a second bit line coupled to the first bit line, and a third bit line coupled to the first bit line, the first bit line extending along a second direction parallel to the base substrate, the second bit line and the third bit line extending along a third direction parallel to the base substrate, and the second direction intersecting with the third direction; the second bit line and the plurality of memory cells are located on one side of the first bit line in the third direction, the third bit line, the first staircase structure, and the second staircase structure are located on the other side of the first bit line in the third direction, and the first staircase structure and the second staircase structure are located on opposite sides of the third bit line in the second direction; the plurality of memory cells are each coupled to a corresponding second bit line, each staircase structure of the first staircase structure and the second staircase structure includes a plurality of conductive steps extending along the second direction, and each conductive step is coupled to a corresponding third bit line.

In the memory provided in the embodiments of the present disclosure, the extension length of the second bit line may be set according to the number of the memory cells coupled thereto, the extension length of the first bit line may be set according to the number of the second bit lines coupled thereto, and the extension length of the third bit line may be set according to the arrangement of the staircase structures coupled thereto, so that the stack structure in the memory can be more compact (i.e., the planar shape thereof has a circumscribed rectangle with a small area), thereby helping to increase the yield of memory chips on each wafer (i.e., the number of dies that can be cut out from each wafer, Die Per Wafer, abbreviated as DPW).

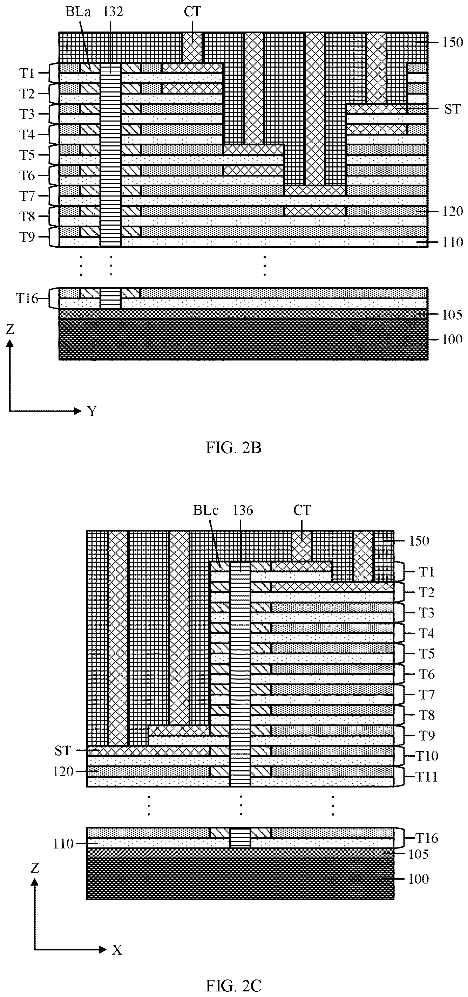

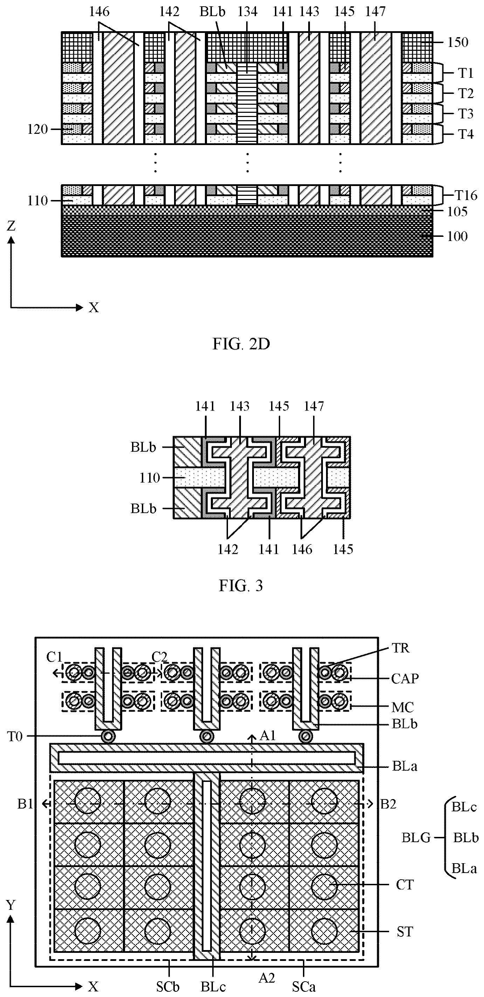

FIG. 2A is a schematic diagram of a partial planar structure of a memory provided according to some embodiments of the present disclosure; FIG. 2B is a schematic diagram of a section taken along line A1-A2 in FIG. 2A; FIG. 2C is a schematic diagram of a section taken along line B1-B2 in FIG. 2A; FIG. 2D is a schematic diagram of a section taken along line C1-C2 in FIG. 2A. It should be noted that in FIG. 2A, some insulating layers and/or dielectric layers in the memory are omitted for clarity and conciseness.

As shown in FIGS. 2A-2D, the memory includes a plurality of bit line functional groups BLG, a plurality of memory cells MC, a first staircase structure SCa, and a second staircase structure SCb located on the base substrate 100. The plurality of bit line functional groups BLG are spaced apart along a first direction Z perpendicular to the base substrate 100, and each bit line functional group BLG includes a first bit line BLa, a second bit line BLb coupled to the first bit line BLa, and a third bit line BLc coupled to the first bit line BLa. The first bit line BLa, the second bit line BLb, and the third bit line BLc in each bit line functional group BLG are at the same tier. The first bit line BLa extends along a second direction X parallel to the base substrate 100, and the second bit line BLb and third bit line BLc extend along a third direction Y parallel to the base substrate 100, the second direction X and the third direction Y are both perpendicular to the first direction Z, and the second direction X intersects with the third direction Y. For example, the second direction X and the third direction Y are perpendicular to each other. For example, orthographic projections of the first bit lines BLa in different bit line functional groups BLG on the base substrate 100 substantially overlap, orthographic projections of the second bit lines BLb in different bit line functional groups BLG on the base substrate 100 substantially overlap, and orthographic projections of the third bit lines BLc in different bit line functional groups BLG on the base substrate 100 substantially overlap.

As shown in FIGS. 2A-2D, the second bit lines BLb and the plurality of memory cells MC are located on one side of the first bit line BLa in the third direction Y, the third bit line BLc, the first staircase structure SCa, and the second staircase structure SCb are located on the other side of the first bit line BLa in the third direction Y, and the first staircase structure SCa and the second staircase structure SCb are located on opposite sides of the third bit line BLc in the second direction X.

As shown in FIGS. 2A-2D, the plurality of memory cells MC are each coupled to a corresponding second bit line BLb; each staircase structure of the first staircase structure SCa and the second staircase structure SCb includes a plurality of conductive steps ST extending along the second direction X, and each conductive step ST is coupled to a corresponding third bit line BLc.

Illustratively, in the embodiment shown in FIGS. 2A-2D, the memory includes a stack structure having 16 tiers (T1-T16). It will be understood that the stack structure in the memory may have more or fewer tiers. For example, the number of tiers of the stack structure in the memory may include, but is not limited to, 32, 64, 128, 256, and the like. The arrangement mode of the conductive steps ST in FIGS. 2A-2D is described below with reference to Table 1.

**Table 1. One arrangement mode of 16 conductive steps**

| Second staircase structure SCb | | First staircase structure SCa | |
|---|---|---|---|
| 10 | 9 | 1 | 2 |
| 14 | 13 | 5 | 6 |
| 16 | 15 | 7 | 8 |
| 12 | 11 | 3 | 4 |

For example, referring to Table 1 and FIGS. 2A-2D, the first staircase structure SCa includes conductive steps ST at tiers T1-T8, and the second staircase structure SCb includes conductive steps ST at tiers T9-T16. The natural number i in the table indicates a conductive step ST at the Ti tier, which is coupled to a third bit line BLc at the same tier (i.e., Ti tier).

Table 2 shows another arrangement mode of the conductive steps ST in FIGS. 2A-2D. The content of Table 2 can be understood with reference to the relevant description of Table 1 and the detailed description will not be repeated here. It will be understood that in the embodiment shown in FIGS. 2A-2D, the arrangement mode of the conductive steps ST is not limited to those shown in Tables 1 and 2 and may include other suitable arrangement modes as long as they facilitate manufacturing.

**Table 2. Another arrangement mode of 16 conductive steps**

| Second staircase structure SCb | | First staircase structure SCa | |
|---|---|---|---|
| 10 | 9 | 1 | 2 |
| 12 | 11 | 3 | 4 |
| 14 | 13 | 5 | 6 |
| 16 | 15 | 7 | 8 |

**Table 3. One arrangement mode of 32 conductive steps**

| Second staircase structure SCb | | First staircase structure SCa | |
|---|---|---|---|
| 18 | 17 | 1 | 2 |
| 22 | 21 | 5 | 6 |
| 26 | 25 | 9 | 10 |
| 30 | 29 | 13 | 14 |
| 32 | 31 | 15 | 16 |
| 28 | 27 | 11 | 12 |
| 24 | 23 | 7 | 8 |
| 20 | 19 | 3 | 4 |

**Table 4. Another arrangement mode of 32 conductive steps**

| Second staircase structure SCb | | | | First staircase structure SCa | | | |
|---|---|---|---|---|---|---|---|
| 20 | 19 | 18 | 17 | 1 | 2 | 3 | 4 |
| 28 | 27 | 26 | 25 | 9 | 10 | 11 | 12 |
| 32 | 31 | 30 | 29 | 13 | 14 | 15 | 16 |
| 24 | 23 | 22 | 21 | 5 | 6 | 7 | 8 |

It will be understood that when the number of tiers of the stack structure in the memory is other values, the conductive steps ST may be arranged with reference to the arrangement mode of Table 1 or Table 2. Tables 3 and 4 each show one arrangement mode of 32 conductive steps. The content of Tables 3 and 4 can be understood with reference to the relevant description of Table 1 and the detailed description will not be repeated here.

For example, in some embodiments, as shown in FIG. 2A, the number of the second bit lines BLb may be set to be plural. It should be noted that the number of the second bit lines BLb and that of the memory cells MC shown in FIG. 2A are all illustrative and should not be construed as limiting the present disclosure.

For example, in some embodiments, as shown in FIG. 2A, each of the first bit line BLa, the second bit line BLb, and the third bit line BLc is ring-shaped. For example, the first bit line BLa may be ring-shaped. For example, the second bit line BLb may be closed ring-shaped or non-closed ring-shaped; for example, in the case where the second bit line BLb is non-closed ring-shaped, an opening of the non-closed ring is located at an end of the second bit line BLb away from the first bit line BLa. For example, the third bit line BLc may be closed ring-shaped or non-closed ring-shaped; for example, in the case where the second bit line BLb is non-closed ring-shaped, an opening of the non-closed ring is located at an end of the third bit line BLc away from the first bit line BLa.

For example, in some embodiments, the first bit line BLa, the second bit line BLb, and the third bit line BLc have the same material composition. For example, materials of the first bit line BLa, the second bit line BLb, and the third bit line BLc may include, but are not limited to, titanium nitride and/or tungsten, and the like. For example, the first bit line BLa, the second bit line BLb, and the third bit line BLc may be formed simultaneously.

For example, in some embodiments, as shown in FIGS. 2A-2D, the memory further includes a first isolation column 132, a second isolation column 134, and a third isolation column 136 located on the base substrate 100. The first bit line BL circumferentially surrounds the first isolation column 132, the second bit line BLb circumferentially surrounds the second isolation column 134, and the third bit line BLc circumferentially surrounds the third isolation column 136.

For example, in some embodiments, the first isolation column 132, the second isolation column 134, and the third isolation column 136 have the same material composition. For example, materials of the first isolation column 132, the second isolation column 134, and the third isolation column 136 may include, but are not limited to, silicon oxide (SiO₂), silicon nitride (SiN), silicon oxynitride (SiON), aluminum oxide, or the like. For example, the first isolation column 132, the second isolation column 134, and the third isolation column 136 may be formed simultaneously.

For example, in some embodiments, each staircase structure of the first staircase structure SCa and the second staircase structure SCb includes a plurality of conductive step groups, and each conductive step group includes at least two conductive steps ST spaced apart along the first direction Z perpendicular to the base substrate 100 and having different extension lengths (refer to the conductive steps located in the same row under the column "first staircase structure SCa" or "second staircase structure SCb" in Tables 1-4); in each conductive step group, a conductive step ST with a smaller extension length is farther away from the base substrate 100 than a conductive step ST with a larger extension length, so that a contact plug CT can be provided on both the conductive step ST with a smaller extension length and the conductive step ST with a larger extension length. Illustratively, referring to FIGS. 2B and 2C, the conductive step ST with a smaller extension length at tier T1 and the conductive step ST with a larger extension length at tier T2 constitute one conductive step group, with the former being farther away from the base substrate 100 than the latter; the conductive step ST with a smaller extension length at tier T3 and the conductive step ST with a larger extension length at tier T4 constitute one conductive step group, with the former being farther away from the base substrate 100 than the latter; the conductive step ST with a smaller extension length at tier T5 and the conductive step ST with a larger extension length at tier T6 constitute one conductive step group, with the former being farther away from the base substrate 100 than the latter; the conductive step ST with a smaller extension length at tier T7 and the conductive step ST with a larger extension length at tier T8 constitute one conductive step group, with the former being farther away from the base substrate 100 than the latter; the conductive step ST with a smaller extension length at tier T9 and the conductive step ST with a larger extension length at tier T10 constitute one conductive step group, with the former being farther away from the base substrate 100 than the latter; and so on.

For example, in some embodiments, each staircase structure of the first staircase structure SCa and the second staircase structure SCb includes a first conductive step and a second conductive step, the first conductive step and the second conductive step have substantially the same extension length, the first conductive step is closer to a middle of the third bit line BLc than the second conductive step, and the first conductive step is closer to the base substrate 100 than the second conductive step. Illustratively, referring to Table 1 and FIGS. 2A and 2B, the conductive step ST at tier T5 and the conductive step ST at tier T1 may serve as a first conductive step and a second conductive step, respectively; the two have substantially the same extension length, and the former is closer to the middle of the third bit line BLc than the latter and the former is closer to the base substrate 100 than the latter; or, the conductive step ST at tier T7 and the conductive step ST at tier T3 level may serve as a first conductive step and a second conductive step, respectively; or, the conductive step ST at tier T6 and the conductive step ST at tier T2 may serve as a first conductive step and a second conductive step, respectively; or, the conductive step ST at tier T8 and the conductive step ST at tier T4 may serve as a first conductive step and a second conductive step, respectively; and so on.

For example, in some embodiments, the first staircase structure SCa includes a third conductive step, and the second staircase structure SCb includes a fourth conductive step. Orthographic projections of the third conductive step and the fourth conductive step on the base substrate 100 are arranged along the second direction X, the third conductive step and the fourth conductive step have substantially the same extension length, and the third conductive step is farther away from the base substrate than the fourth conductive step. Illustratively, referring to Table 1 and FIGS. 2A and 2C, the conductive step ST at tier T1 and the conductive step ST at tier T9 may serve as a third conductive step and a fourth conductive step, respectively, orthographic projections of the former and the latter on the base substrate 100 are arranged along the second direction X, the former and the latter have substantially the same extension length, and the former is farther away from the base substrate 100 than the latter; or, the conductive step ST at tier T2 and the conductive step ST at tier T10 may serve as a third conductive step and a fourth conductive step, respectively; and so on.

For example, in some embodiments, referring to Table 1 (or Tables 2-4) and FIGS. 2A and 2C, each conductive step ST in the first staircase structure SCa is farther away from the base substrate 100 than any one conductive step ST in the second staircase structure SCb.

It will be understood that the first staircase structure SCa and the second staircase structure SCb may be interchanged.

For example, in some embodiments, as shown in FIGS. 2A-2C, the memory further includes a plurality of contact plugs CT, which are located on the conductive steps ST in a one-to-one correspondence. For example, each contact plug CT is integrally formed with a corresponding conductive step ST. For example, the contact plug CT and the conductive step ST have the same material composition. For example, materials of the contact plug CT and the conductive step ST may include, but are not limited to, titanium nitride and/or tungsten, and the like.

For example, in some embodiments, as shown in FIGS. 2A and 2D, memory cells MC coupled to each second bit line BLb are disposed on opposite sides of the each second bit line BLb in the second direction X. For example, each memory cell MC includes an access transistor TR coupled to a corresponding second bit line BLb and a capacitor CAP coupled to the access transistor TR. It should be noted that the memory cell MC may not be limited to a DRAM (dynamic random access memory) memory cell. For example, the memory cell MC may also be an FeRAM (ferroelectric random access memory) memory cell, a PCM (phase change memory) memory cell, an MRAM (magnetic random access memory) memory cell, or the like. That is, the memory provided by the embodiments of the present disclosure may be a DRAM, an FeRAM, a PCM, an MRAM, or the like.

For example, in some embodiments, as shown in FIGS. 2A and 2D, the access transistor TR includes a first gate 143, a first active layer 141 surrounding the first gate 143, and a first gate dielectric layer 142 between the first gate and the first active layer 141, i.e., the access transistor TR may be a Channel-All-Around (CAA) transistor; the first gates 143 oppositely arranged along the first direction Z are connected to form an integrated structure (i.e., a word line 143), the first gate dielectric layers 142 oppositely arranged along the first direction Z are connected to form an integrated structure, and the first active layers 141 oppositely arranged along the first direction Z are spaced apart and are each coupled to a corresponding second bit line BLb. For example, the material of the first active layer 141 may include, but is not limited to, polysilicon, metal oxide, or the like, and the metal oxide may be, e.g., indium gallium zinc oxide (IGZO). For example, the material of the first gate insulating layer 142 may include, but is not limited to, silicon oxide (SiO₂) and/or a high-K dielectric, or the like. For example, the material of the word line 143 may include, but is not limited to, titanium nitride and/or tungsten, or the like.

For example, in some embodiments, as shown in FIGS. 2A and 2D, the capacitor CAP includes a first electrode 147, a second electrode 145 surrounding the first electrode 147, and a capacitor dielectric layer 146 between the first electrode 147 and the second electrode 145; the first electrodes 147 oppositely arranged along the first direction Z are connected to form an integrated structure (i.e., a common electrode 147), the capacitor dielectric layers 146 oppositely arranged along the first direction Z are connected to form an integrated structure, and the second electrodes 145 oppositely arranged along the first direction Z are spaced apart and are each coupled to a corresponding access transistor TR. For example, the material of the second electrode 145 may include, but is not limited to, titanium nitride and/or tungsten, or the like. For example, the material of the capacitor dielectric layer 146 may include, but is not limited to, silicon oxide (SiO₂) and/or a high-K dielectric, or the like. For example, the material of the first electrode 147 may include, but is not limited to, titanium nitride and/or tungsten, or the like.

It should be noted that the structures of the memory cell MC (i.e., the access transistor TR and the capacitor CAP) shown in FIG. 2D are illustrative. FIG. 3 is a schematic structural diagram of a memory cell (including an access transistor and a capacitor) provided according to some embodiments of the present disclosure. For example, as shown in FIG. 3, in some embodiments, in the access transistor TR of the memory cell MC, a portion of the cross section of the first active layer 141 is C-shaped, the first gate dielectric layer 142 conformally covers the first active layer 141, and the word line 143 includes branches extending laterally into the C-shaped openings of the first active layer 141. For example, as shown in FIG. 3, in some embodiments, in the capacitor CAP of the memory cell MC, a portion of the cross section of the second electrode 145 is C-shaped, the capacitor dielectric layer 146 conformally covers the second electrode 145, and the common electrode 147 includes branches extending laterally into the C-shaped openings of the second electrode 145.

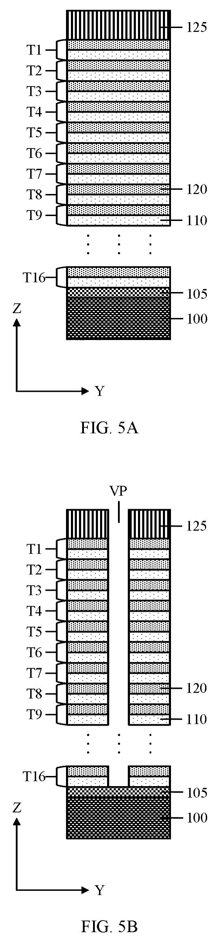

FIG. 4 is a schematic diagram of a partial planar structure of another memory provided according to some embodiments of the present disclosure. For example, in some embodiments, on the basis of the memory shown in FIG. 2, the memory shown in FIG. 4 may further include a plurality of select transistors T0; in each bit line functional group BLG, each second bit line BLb is coupled to the first bit line BLa through a corresponding select transistor T0.

For example, in some embodiments, the structure and material composition of the select transistor T0 may be the same as those of the access transistor TR. For example, the select transistor T0 includes a second gate (refer to the first gate 143 described above), a second active layer (refer to the first active layer 141 described above) surrounding the second gate, and a second gate dielectric layer (refer to the first gate dielectric layer 142 described above) between the second gate and the second active layer, that is, the select transistor T0 may be a Channel-All-Around (CAA) transistor; the second gates oppositely arranged along the first direction Z are connected to form an integrated structure (i.e., a select control line), the second gate dielectric layers oppositely arranged along the first direction Z are connected to form an integrated structure, and the second active layers oppositely arranged along the first direction Z are spaced apart and are respectively coupled to a corresponding first bit line BLa and a corresponding second bit line BLb. For example, the select transistor T0 and the access transistor TR may be formed simultaneously.

FIGS. 5A-5C are schematic diagrams of partial sectional structures of some stages in a manufacturing process of a memory provided according to some embodiments of the present disclosure. The manufacturing process of the bit line functional group BLG and the memory cell MC will be briefly described below with reference to FIGS. 5A-5C.

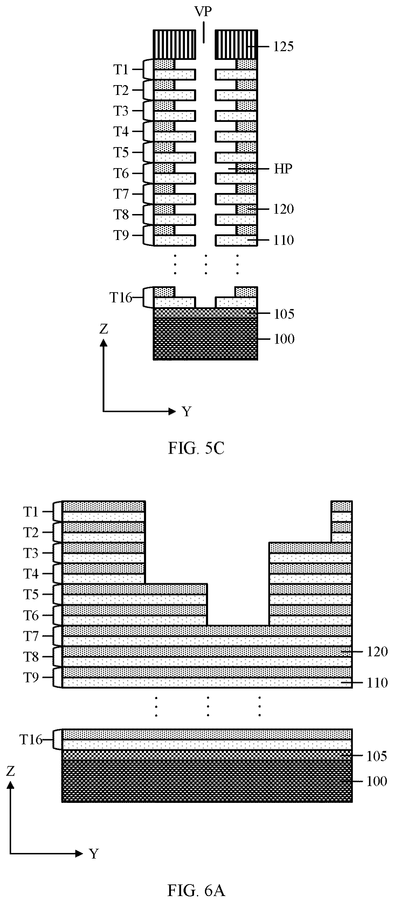

For example, in some embodiments, the manufacturing process of the bit line functional group BLG may include: referring to FIG. 5A, sequentially forming an etching stop layer 105, alternately stacked first dielectric layers 110 and second dielectric layers 120, and a mask layer 125 are on a base substrate 100, where adjacent first dielectric layer 110 and second dielectric layer 120 constitute a tier; then, referring to FIG. 5B, forming an opening pattern on the mask layer 125, and etching the alternately stacked first dielectric layers 110 and second dielectric layers 120 to form a vertical opening VP, where the vertical opening VP exposes an upper surface of the etching stop layer 105; next, referring to FIG. 5C, laterally etching from the vertical opening VP to remove a portion of the second dielectric layer 120 in each tier to form horizontal openings HP; thereafter, referring to the first bit lines BLa and the first isolation column 132 in FIG. 2B, forming the first bit lines BLa in the horizontal openings HP, and forming the first isolation column 132 filling the vertical opening VP. It will be understood that the formation process of the second bit line BLb and the second isolation column 134 is similar to that of the first bit line BLa and the first isolation column 132, and the formation process of the third bit line BLc and the third isolation column 136 is also similar to that of the first bit line BLa and the first isolation column 132, and thus, the detailed description will not be repeated here. It will also be understood that, in the process of forming the first bit line BLa, the second bit line BLb, and the third bit line BLc, the three need to satisfy the corresponding coupling relationship.

For example, in some embodiments, the manufacturing process of the access transistor TR in the memory cell MC may include: referring to FIG. 5B, forming an opening pattern on the mask layer 125, and etching the alternately stacked first dielectric layers 110 and second dielectric layers 120 to form a vertical opening VP, where the vertical opening VP exposes an upper surface of the etching stop layer 105; next, referring to FIG. 5C, laterally etching from the vertical opening VP to remove a portion of the second dielectric layer 120 in each tier to form horizontal openings HP; thereafter, referring to the first active layer 141, the first gate dielectric layer 142, and the word line WL in FIG. 2D or FIG. 3, forming the first active layers 141 in the horizontal openings HP, forming the first gate dielectric layers 142 conformally covering the first active layers 141, and forming the word line 143 filling the vertical opening VP. It will be understood that if the second bit line BLb is formed prior to the first active layer 141, the horizontal opening on one side accommodating the first active layer 141 should expose a sidewall of the second bit line BLb so that the first active layer 141 formed later can be coupled to the second bit line BLb formed earlier; similarly, if the second electrode 145 of the capacitor CAP is formed prior to the first active layer 141, the horizontal opening on the other side accommodating the first active layer 141 should expose a sidewall of the second electrode 145 so that the first active layer 141 formed later can be coupled to the second electrode 145 formed earlier. It will also be understood that the formation process of the select transistor T0 may be similar to that of the access transistor TR and the detailed description will not be repeated here.

For example, in some embodiments, the manufacturing process of the capacitor CAP in the memory cell MC may include: referring to FIG. 5B, forming an opening pattern on the mask layer 125, and etching the alternately stacked first dielectric layers 110 and second dielectric layers 120 to form a vertical opening VP, where the vertical opening VP exposes an upper surface of the etching stop layer 105; next, referring to FIG. 5C, laterally etching from the vertical opening VP to remove a portion of the second dielectric layer 120 in each tier to form horizontal openings HP; thereafter, referring to the first active layer 141, the first gate dielectric layer 142, and the word line WL in FIG. 2D or FIG. 3, forming the second electrodes 145 in the horizontal openings HP, forming the capacitor dielectric layers 146 conformally covering the second electrodes 145, and forming the common electrode 147 filling the vertical opening VP. It will be understood that if the first active layer 141 is formed prior to the second electrode 145, the horizontal opening on one side accommodating the second electrode 145 should expose a sidewall of the first active layer 141 so that the second electrode 145 formed later can be coupled to the first active layer 141 formed earlier.

FIGS. 6A-6F are schematic diagrams of partial sectional structures of other stages in a manufacturing process of a memory provided according to other embodiments of the present disclosure. The manufacturing process of the first staircase structure SCa and the second staircase structure SCb will be briefly described below with reference to FIGS. 6A-6F.

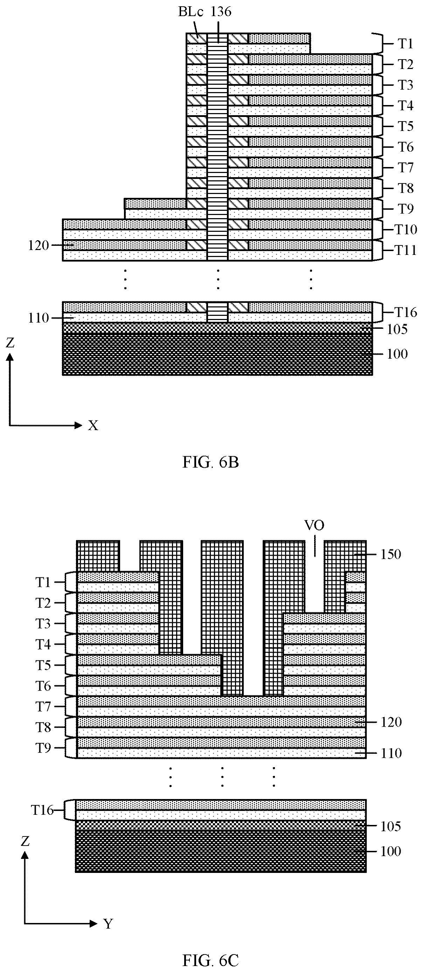

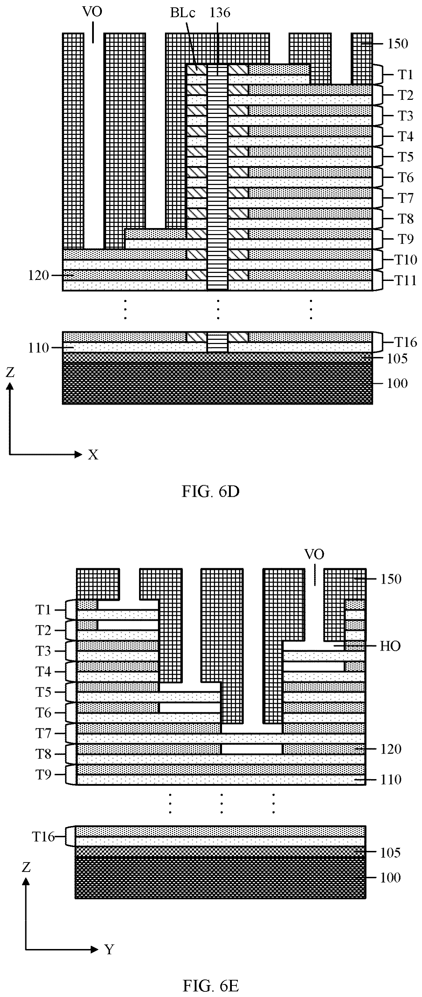

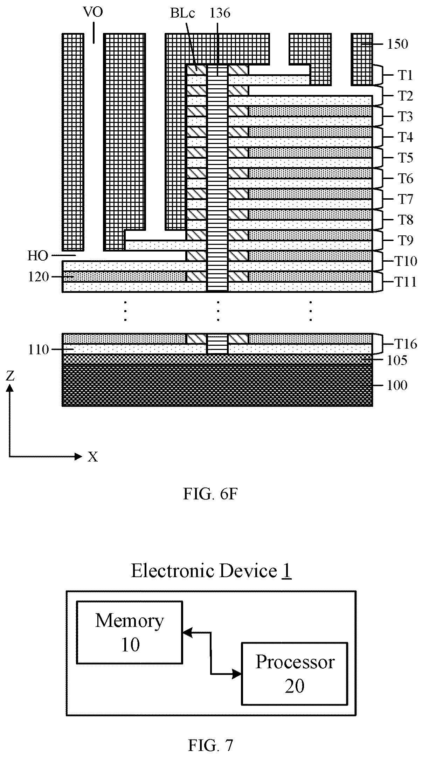

For example, in some embodiments, the manufacturing process of the first staircase structure SCa and the second staircase structure SCb may include: referring to FIGS. 6A and 6B, etching the alternately stacked first dielectric layers 110 and second dielectric layers 120 to form a first initial staircase structure and a second initial staircase structure (thereafter, the mask layer 125 can be removed); then, referring to FIGS. 6C and 6D, forming a planarization layer 150 covering the first initial staircase structure and the second initial staircase structure, and forming vertical openings VO in the planarization layer 150, where the vertical openings VO expose the second dielectric layer 120 on the top of each initial staircase; next, referring to FIGS. 6E and 6F, etching the second dielectric layer 120 at the top of each initial staircase from the vertical opening VO to form horizontal openings HO, where the horizontal opening HO exposes a sidewall of the third bit line BLc; thereafter, referring to FIGS. 2 and 2C, forming conductive steps ST in the horizontal openings HO, and forming contact plugs CT in the vertical openings VO, thereby obtaining the first staircase structure SCa and the second staircase structure SCb. For example, the conductive step ST and the contact plug CT may be formed simultaneously by depositing a conductive material.

For example, in an embodiment of the present disclosure, the base substrate 100 may include, but is not limited to, a silicon substrate, a silicon-on-insulator substrate, and the like. For example, the material of the etching stop layer 105 may include, but is not limited to, silicon carbide (SiC), silicon carbon oxide (SiCO), silicon carbon nitride (SiCN), or the like. For example, the material of the first dielectric layer 110 may include, but is not limited to, silicon oxide (SiO₂), silicon nitride (SiN), silicon oxynitride (SiON), or the like. For example, the material of the second dielectric layer 120 may include, but is not limited to, silicon oxide (SiO₂), silicon nitride (SiN), silicon oxynitride (SiON), or the like. For example, the material of the mask layer 125 may include, but is not limited to, silicon nitride (SiN), silicon carbide (SiC), silicon carbon nitride (SiCN), or the like. For example, the material of the planarization layer 150 may be the same as that of the first dielectric layer 110, but is not limited thereto.

It will be understood that the materials of the etching stop layer 105, the first dielectric layer 110, and the second dielectric layer 120 are usually different from each other, and there is usually a certain etch selectivity between every two layers. Similarly, the materials of the first dielectric layer 110, the second dielectric layer 120, and the mask layer 125 are usually different from each other, and there is usually a certain etch selectivity between every two layers.

In the memory provided in the embodiments of the present disclosure, the extension length of the second bit line BLb may be set according to the number of the memory cells MC coupled thereto, the extension length of the first bit line BLa may be set according to the number of the second bit lines BLb coupled thereto, and the extension length of the third bit line BLc may be set according to the arrangement of the staircase structures SCa and SCb coupled thereto, so that the stack structure in the memory can be more compact (i.e., the planar shape thereof has a circumscribed rectangle with a small area), thereby helping to increase the yield of memory chips on each wafer (i.e., the number of dies that can be cut out from each wafer, Die Per Wafer, abbreviated as DPW).

In at least some embodiments of the present disclosure, further provided is an electronic device. FIG. 7 is a block diagram illustrating a structure of an electronic device provided according to some embodiments of the present disclosure. As shown in FIG. 7, the electronic device 1 includes a processor 20 and a memory 10 coupled to each other, where the memory 10 is one provided in any one of the foregoing embodiments.

For example, the processor 20 may include, but is not limited to, a Central Processing Unit (CPU), a Graphics Processing Unit (GPU), and the like. The memory 10 may be configured to store data to be processed by the processor 20 and/or data that have been processed by the processor.

For example, the electronic device 1 includes, but is not limited to, a cell phone, a tablet, a smart bracelet, a wearable electronic device, a virtual reality device, an augmented reality device, an in-vehicle device, a server, a workstation, and the like.

The above description is only the specific embodiments of the present disclosure, but the scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A memory, comprising: a plurality of bit line functional groups (BLG), a plurality of memory cells (MC), a first staircase structure (SCa), and a second staircase structure (SCb) located on a base substrate (100);
wherein, the plurality of bit line functional groups are spaced apart along a first direction (Z) perpendicular to the base substrate, and each bit line functional group of the plurality of bit line functional groups comprises a first bit line (BLa), a second bit line (BLb) coupled to the first bit line, and a third bit line (BLc) coupled to the first bit line, the first bit line extending along a second direction (X) parallel to the base substrate, the second bit line and the third bit line extending along a third direction (Y) parallel to the base substrate, and the second direction intersecting with the third direction;
the second bit line and the plurality of memory cells are located on one side of the first bit line in the third direction, the third bit line, the first staircase structure, and the second staircase structure are located on the other side of the first bit line in the third direction, and the first staircase structure and the second staircase structure are located on opposite sides of the third bit line in the second direction;
the plurality of memory cells are each coupled to a corresponding second bit line, each staircase structure of the first staircase structure and the second staircase structure comprises a plurality of conductive steps (ST) extending along the second direction, and each conductive step is coupled to a corresponding third bit line.

2. The memory according to claim 1, wherein each of the first bit line, the second bit line, and the third bit line is ring-shaped.

3. The memory according to claim 1 or 2, wherein the first bit line, the second bit line, and the third bit line have the same material composition.

4. The memory according to any one of claims 1-3, further comprising: a first isolation column (132), a second isolation column (134), and a third isolation column (136) located on the base substrate;
wherein, the first bit line circumferentially surrounds the first isolation column, the second bit line circumferentially surrounds the second isolation column, and the third bit line circumferentially surrounds the third isolation column.

5. The memory according to claim 4, wherein the first isolation column, the second isolation column, and the third isolation column have the same material composition.

6. The memory according to any one of claims 1-5, wherein each staircase structure of the first staircase structure and the second staircase structure comprises a plurality of conductive step groups, and each conductive step group comprises at least two conductive steps spaced apart along the first direction perpendicular to the base substrate and having different extension lengths;
in each conductive step group, a conductive step with a smaller extension length is farther away from the base substrate than a conductive step with a larger extension length.

7. The memory according to any one of claims 1-6, wherein each staircase structure of the first staircase structure and the second staircase structure comprises a first conductive step and a second conductive step, the first conductive step and the second conductive step have substantially the same extension length, the first conductive step is closer to a middle of the third bit line than the second conductive step, and the first conductive step is closer to the base substrate than the second conductive step.

8. The memory according to any one of claims 1-7, wherein the first staircase structure comprises a third conductive step, and the second staircase structure comprises a fourth conductive step; orthographic projections of the third conductive step and the fourth conductive step on the base substrate are arranged along the second direction, the third conductive step and the fourth conductive step have substantially the same extension length, and the third conductive step is farther away from the base substrate than the fourth conductive step.

9. The memory according to any one of claims 1-8, wherein each conductive step in the first staircase structure is farther away from the base substrate than any one conductive step in the second staircase structure.

10. The memory according to any one of claims 1-9, further comprising:
a plurality of contact plugs (CT) located on the conductive steps in a one-to-one correspondence, wherein each contact plug is integrally formed with a corresponding conductive step.

11. The memory according to any one of claims 1-10, wherein memory cells coupled to each second bit line are disposed on opposite sides of the each second bit line in the second direction.

12. The memory according to any one of claims 1-11, wherein each memory cell comprises an access transistor (TR) coupled to a corresponding second bit line and a capacitor (CAP) coupled to the access transistor.

13. The memory according to claim 12, wherein the access transistor comprises a first gate (143), a first active layer (141) surrounding the first gate, and a first gate dielectric layer (142) between the first gate and the first active layer;
the first gates oppositely arranged along the first direction are connected to form a word line (143), the first gate dielectric layers oppositely arranged along the first direction are connected to form an integrated structure, and the first active layers oppositely arranged along the first direction are spaced apart and are each coupled to a corresponding second bit line.

14. The memory according to claim 12 or 13, wherein the capacitor comprises a first electrode (147), a second electrode (145) surrounding the first electrode, and a capacitor dielectric layer (146) between the first electrode and the second electrode;
the first electrodes oppositely arranged along the first direction are connected to form an integrated structure, the capacitor dielectric layers oppositely arranged along the first direction are connected to form an integrated structure, and the second electrodes oppositely arranged along the first direction are spaced apart and are each coupled to a corresponding access transistor.

15. The memory according to any one of claims 1-14, wherein the number of the second bit lines is set to be plural.

16. The memory according to claim 15, further comprising:
a plurality of select transistors (T0), wherein in each bit line functional group, each second bit line is coupled to the first bit line through one corresponding select transistor.

17. The memory according to claim 16, wherein the select transistor comprises a second gate, a second active layer surrounding the second gate, and a second gate dielectric layer between the second gate and the second active layer;
the second gates oppositely arranged along the first direction are connected to form a select control line, the second gate dielectric layers oppositely arranged along the first direction are connected to form an integrated structure, and the second active layers oppositely arranged along the first direction are spaced apart and are respectively coupled to a corresponding first bit line and a corresponding second bit line.

18. An electronic device, comprising:
a processor (20); and
the memory (10) according to any one of claims 1-17, wherein the memory is coupled to the processor.
